Europäisches Patentamt

European Patent Office

Office européen des brevets

(11) Publication number: **0 073 486**
**B1**

# (12) EUROPEAN PATENT SPECIFICATION

(45) Date of publication of patent specification: **05.04.89**

(51) Int. Cl.⁴: **G 11 C 5/02, G 11 C 5/04**

(21) Application number: **82107858.1**

(22) Date of filing: **26.08.82**

(54) Stacked semiconductor memory.

(30) Priority: **31.08.81 JP 136399/81**

(43) Date of publication of application:
**09.03.83 Bulletin 83/10**

(45) Publication of the grant of the patent:
**05.04.89 Bulletin 89/14**

(84) Designated Contracting States:
**DE FR GB IT**

(56) References cited:
**DE-A-2 806 685**
**FR-A-2 088 490**

(73) Proprietor: **KABUSHIKI KAISHA TOSHIBA**
**72, Horikawa-cho Saiwai-ku**
**Kawasaki-shi Kanagawa-ken 210 (JP)**

(72) Inventor: **Toyama, Masaharu**
**3888-10, Akuwa-cho Seya-ku**
**Yokohama-shi (JP)**

(74) Representative: **Lehn, Werner, Dipl.-Ing. et al**
**Hoffmann, Eitle & Partner Patentanwälte**
**Arabellastrasse 4**
**D-8000 München 81 (DE)**

Courier Press, Leamington Spa, England.

EP 0 073 486 B1

## Description

The present invention relates to semiconductor memories and, more particularly, to a sterosocopic semi-conductor memory formed by stacking a plurality of semiconductor layers.

A semiconductor memory including a read-only memory (ROM) and a random access memory (RAM) normally has a plurality of memory cells formed on the same plane or surface of a substrate. These memory cells are arrayed in a matrix shape on the surface of the substrate. One linear memory cell array arranged in a row direction of the memory cell matrix is connected commonly to one word line. Similarly, the remaining linear memory cell arrays arranged in the row direction are commonly connected to word lines. On the other hand, the linear memory cell array arranged in a column direction of the memory cell matrix is connected commonly to one bit line. The remaining memory cell arrays arranged in the column direction are similarly connected commonly to the bit lines, respectively. The above-described plurality of word lines and bit lines extend substantially on the same plane or surface on the substrate. More particularly, the word lines and bit lines extend on the plane in parallel relation to the memory cell matrix. The word lines extend in parallel with each other, while bit lines extend in parallel with each other. In other words, the every memory cell is connected to one word line and one bit line corresponding to the intersection between the word line and the bit line.

When an address signal is inputted to the semiconductor memory, e.g., a dynamic RAM and one word line of the word lines is activated in response to the signal, transfer gates of a plurality of memory cells, contained in the memory cell array connected commonly to the word line, are opened. In this manner, the memory content stored at least one desired memory cell of the memory cells opened at the transfer gates thereof is read by the bit line, or the data supplied to the bit lines can be written or stored in the memory cell opened at the transfer gate thereof.

According to an ordinary semiconductor memory thus composed, since a number of memory cells are arranged substantially on the same plane, the integration determined in response to the area of the surface of the substrate is restricted to a predetermined upper limit. When the memory integration exceeding the upper limit is necessary, it is required to increase the area of the semiconductor substrate, and the profile of a memory cell is undesirably enlarged. In this case, the lengths of the word lines and the bit lines also become lengthened, with the result that a delay of a signal propagation undesirably takes place.

According further to the above-mentioned ordinary semiconductor memory, the number of bit lines to be provided also has a limit. In the above-described dynamic RAM, one bit line may be provided in one memory array extending in the column direction of the memory cell matrix.

However, in case of a static RAM, normal and reverse potentials are necessary for one memory array of the column direction as readily understood by those skilled in the art to which the present invention pertains, two bit lines are necessarily provided for each column memory array. Thus, according to the conventional memory configuration, it is difficult to always obtain sufficient space for such bit lines. This becomes a serious problem in case of sorting the memory content or in case of employing the static RAM as an associative memory. If the allowable number of bit lines capable of forming on the same plane or surface is less than the number of bit lines to be originally necessary, data reading/writing operation should be, in case of large quantity of necessary memory content, sequentially respectively carried out from the end of the memory cell matrix. As a consequence, the time required to read/write the data is increased, and the operating speed of the memory cell is undesirably decreased. Accordingly, the use of such memory cells is limited. For example, this memory cannot be used for the field which indpensably requires high operating speed in the memory such as picture information processing.

From GB—A—1300881 (=FR—A—2 088 490, a stacked arrangement of two or more semiconductor bodies is known in which each semiconductor body has a plurality of storage elements thereon. Each semiconductor body has four address lines on one edge and further four address lines on a perpendicular edge for addressing individual ones of the semiconductor storage elements. For the supply of data, so-called "digit conductors" are connected in pairs to the respective semiconductor bodies. Each individual semiconductor element is thus identified by use of the address lines and data is supplied in common to all the semiconductor elements on each body via the respective pair of bit lines. This technique is specifically designed to avoid the need for lines to pass through the center of the semiconductor bodies. Furthermore, the disclosed structure is designed to reduce the number of connecting wiring lines as much as possible. According to the disclosed teaching, both word lines and bit lines for a two dimensional cell matrix formed on each semiconductor body are formed horizontally on the semiconductor layer surface.

No decoder device for use with the stacked semiconductor storage array is disclosed in GB—A—1300881.

An object of the present invention is to provide a new and improved semiconductor memory which has a large memory capacity and a fast operating speed.

According to one aspect of the present invention there is provided a semiconductor memory having a plurality of semiconductor layers sequentially stacked with each other to form a laminar structure, a plurality of memory cells formed on each of said semiconductor layers in a matrix form, and a plurality of insulative layers each sandwiched between the respective semi- conductor layers for electrical insulation therebetween, characterised in that said memory device comprises:

a plurality of word lines each assigned to a corresponding semiconductor layer to commonly couple the memory cells on that semiconductor layer; and

a number of bit lines each of which electrically connects a set of memory cells which are formed on said semiconductor layers respectively and are stacked one above another in a direction substantially perpendicular to surfaces of said semiconductor layers and said insulative layers, which are alternatingly stacked on one another, said bit lines running through said semiconductor layers and said insulative layers to allow electrical signals to be transferred through said semiconductor and insulative layers.

According to a further aspect of the invention there is provided a semiconductor memory system comprising a semiconductor memory and decoder means for receiving an address input signal and for activating desired memory cells of said semiconductor memory, wherein said semiconductor memory comprises a plurality of layers electrically isolated from each other and sequentially stacked to form a laminar structure, a plurality of cell matrix structures having a plurality of memory cells aligned in row and column directions on the surfaces of said layers, a plurality of bit lines for commonly connecting a plurality of the first linear memory cell arrays respectively formed of memory cells arranged in the same column direction of the memory cells included in the cell matrix structure on each of said layers and a plurality of word lines for commonly connecting a plurality of second linear memory cell arrays formed of memory cells arranged in the same row direction of the memory cells included in the memory cell matrix structure on each of said layers and substantially orthogonally intersecting the first linear memory cell arrays, characterized in that said decoder means is electrically connected through said word lines to said semiconductor memory, stacked correspondingly to laminar units formed respectively of said plurality of second linear memory cell arrays stacked via said layers and formed by arranging in parallel with each other a plurality of linear decoder element arrays respectively formed of a plurality of stacked decoder elements including active elements, each of said linear decoder element arrays including wiring means for commonly connecting said plurality of word lines which respectively connect a plurality of second linear memory cell arrays stacked with each other and included in each of said laminar units corresponding to the linear decoder element array and for connecting between predetermined said active elements provided therein, said wiring means extending to substantially orthogonally intersect said layers.

The present invention is best uderstood by reference to the accompanying drawings, of which:

Fig. 1 is a perspective view showing a part of dynamic random access memory (RAM) having stereoscopic memory cell structure according to one preferred embodiment of the present invention in a model;

Fig. 2 is a perspective view clearly showing the wires of word lines and bit lines of the RAM in Fig. 1;

Fig. 3 is a view enlargedly showing one of the linear memory cell arrays having the same row number and column number of the memory cells included in the RAM in Fig. 1 and superposed with each other via semiconductor layers;

Fig. 4 is a perspective view showing a part of the dynamic RAM similar to that of prior art (GB—A—1300881);

Fig. 5 is a perspective view schematically showing a part of the RAM configuration in Fig. 4 as one example of an address decoder having a laminar structure for the RAM in Fig. 4;

Fig. 6 is a perspective view showing the internal configuration of a part of the address decoder in Fig. 5;

Fig. 7 is a diagram showing an equivalent circuit of the circuit arrangement in Fig. 6; and

Fig. 8 is a view showing one of the linear memory cell arrays having the same row number and column number of the memory cells included in a static RAM according to a modification of the dynamic RAM of Fig. 1, each of the memory cells being included in the linear memory cell formed of flip-flops and the cells being connected commonly to a pair of bit lines.

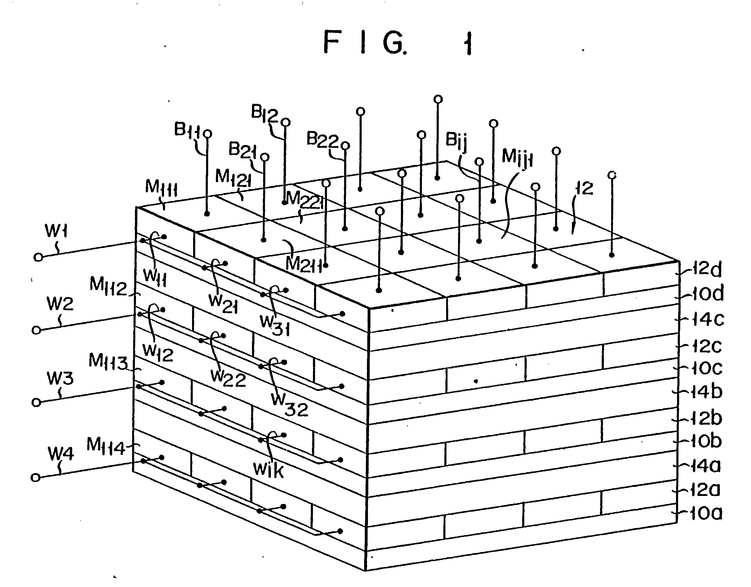

Referring now to Fig. 1, there is schematically illustrated a dynamic RAM of the laminar semiconductor memory according to one preferred embodiment of the present invention. In Fig. 1, only a part of the semiconductor memory is extracted and shown to readily understand the present invention. Semiconductive layers 10b, 10c, 10d, ... are sequentially stacked and formed on a semiconductor layer or substrate 10a. A plurality of memory cells 12 formed, for example, of MOSFETS are formed in a matrix shape on the surface of each of semiconductor layers 10a, 10b, 10c, 10d, .... The semiconductor layers 10a, 10b, 10c, 10d, ... are electrically insulated from each other by electrically insulative layers 14a, 14b, 14c, .... In other words, a two-dimensional (planar) memory cell array 12 is formed on the semiconductor layer 10a, and a second semiconductor layer 10b is formed on the insulating layer 14a formed on the array 12a. The planar memory cell arrays 12a, 12c, 12d, ... are respectively formed on the semiconductor layers 10b, 10c, 10d, ... similarly to the above and electrically insulated from each other by insulating layers 14.

To suitably show the memory cells arranged in three-dimensional and hence stereoscopical manner, one of memory cells is represented by $M_{ijk}$ (i=1, 2, 3, ..., j=1, 2, 3, ..., k=1, 2, 3, ...). The letter "i" designates the row number of the planar cell array formed on one of the semiconductor layers. The letter "j" denotes the column number of the planar cell arrays. The letter "k" designates the number of the planar cell arrays superposed in laminar state, and in Fig. 1, the planar cell array disposed on the uppermost layer is denoted by $k=1$.

In Fig. 1, the memory cells included in the planar memory cell array 12d formed on the semiconductive layer 10d drawn to be disposed at the uppermost stage are connected to a word line W1. The memory cells $M_{111}$, $M_{121}$, ... forming the first row of a plurality of memory cells included in the planar cell array 12d and arranged in matrix shape are connected commonly to the word line $w_{11}$. The word line $w_{11}$ is formed in accordance with the prior art to extend substantially in parallel with the surface of the layer 10d. The linear cell array, formed of memory cells $M_{211}$, $M_{221}$, ... forming the second row of the memory cells included in the planar cell array 12d, is connected commonly to the word line $w_{21}$. Similarly to the above, all the linear row cell arrays included in the planar matrix array 12d are respectively connected commonly to the word lines $w_{31}$, ... . The word lines $w_{11}$, $w_{21}$, $w_{31}$, ... are combined with the single word line (parent word line) W1 at the position in the vicinity of the planar cell array 12d substantially out of the planar cell array 12d. In other words, one word line W1 is branched to a plurality of word lines $w_{11}$, $w_{21}$, $w_{31}$, ... at the above described predetermined position, and the branched word lines $w_{11}$, $w_{21}$, $w_{31}$, ... are electrically commonly connected between the memory cells linearly arranged in the row direction of a plurality of memory cells included in the planar cell array 12d. The word line W1 and a plurality of word lines $w_{11}$, $w_{21}$, $w_{31}$, ... branched from the parent word line W1 are included in an imaginary plane substantially parallel to the surface of the semiconductive layer 10d.

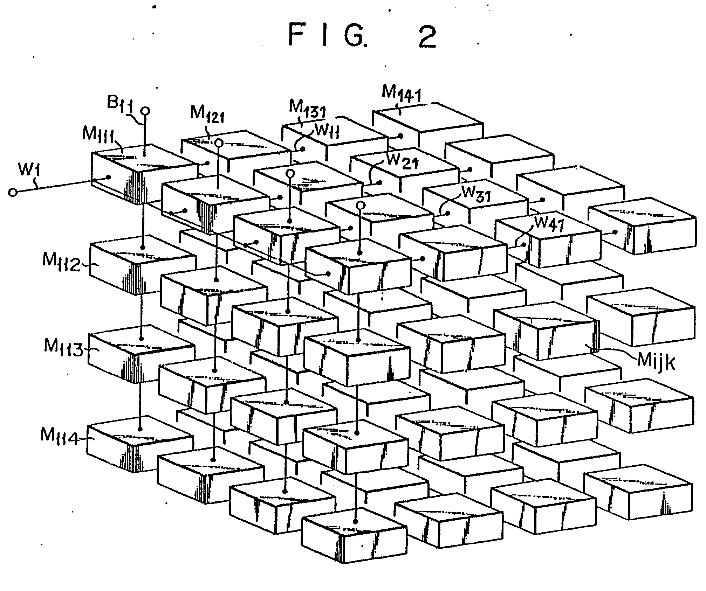

A plurality of word lines $w_{12}$, $w_{22}$, $w_{32}$, ... are each connected in the similar manner to the above to a plurality of linear row cell arrays of planar cell array 12c formed on the semiconductive layer 10c formed to be electrically isolated by the insulating layer 14b from the layer 10c under the semiconductive layer 10d. These word lines $w_{12}$, $w_{22}$, $w_{32}$, ... are combined with one parent word line W2. Similarly to the above, the word lines W3, W4 are connected to the other planar cell arrays 12b, 12a. The connecting state of the word lines are understood more clearly with reference to the model view of the semiconductor memory exploded and designated virtually in the respective memory cells in Fig. 2.

In Fig. 1, a plurality of bit lines B are further connected to the above-described memory cell structure connected with the above word lines W1, W2, W3, W4. These bit lines B substantially extend perpendicularly to the branched word line patterns. In other words, each of bit lines $B_{ij}$ ($i=1, 2, 3, ... , j=1, 2, 3, ...$) is perpendicularly extended to the planar cell arrays 12 each formed on the semiconductor layers 10, and connected commonly to the stacked memory cell group arranged to be linearly aligned to each other in a direction substantially perpendicular to one of the planar memory cell arrays 12. The bit line $B_{11}$ of the bit lines $B_{ij}$, for example, connects commonly one memory cell $M_{111}$, included in the planar cell array 12d, a memory cell $M_{112}$ included in the planar cell array 12c and disposed directly under the memory cell $M_{111}$, a memory cell $M_{113}$ included in the planar cell array 12b and disposed directly under the memory cell $M_{112}$, and a memory cell $M_{114}$ included in the planar cell array 12a and disposed directly under the memory cell $M_{113}$ through the semiconductor layers 10d, 10c, 10b. The connecting state of the memory cell structure of the bit line $B_{11}$ is further clarified with reference to Fig. 2. The other bit lines including the bit lines $B_{12}$ and bit lines $B_{21}$, ... are provided substantially perpendicularly crossed to the word line patterns or the planar cell array 12 in the similar manner to the above.

In other words, the memory cells $M_{11k}$, $M_{12k}$, $M_{21k}$, $M_{22k}$ formed respectively on the same semiconductor layers 12 of the memory cells of the semiconductor memory in Fig. 1 are eventually respectively connected commonly to the parent word lines W1, W2, W3, W4. On the other hand, the memory cells $M_{ij1}$, $M_{ij2}$, ..., and $M_{ij3}$, $M_{hj4}$, ... having the same row number and column number and formed on the different semiconductor layer are respectively connected commonly to the bit lines $B_{11}$, $B_{12}$, ..., $B_{21}$, $B_{22}$, ... . Accordingly, when an address signal is supplied, one word line of the above word lines Wk is activated in response to the signal. Therefore, when one word line, e.g., word line W1, is activated, all the memory cells $M_{ij1}$ included in the planar cell array 12d connected to the word line W1 is activated and the transfer gates thereof are caused to open. In this state, at least one bit line $B_{ij}=B_{12}$ is designated for one desired memory cell, e.g., $M_{121}$ of these memory cells $M_{ij1}$, the digital data supplied to the bit line $B_{12}$ can be written. The digital data stored as described above in the memory cell $M_{121}$ can be read out by designating the bit line $B_{12}$ at desired time similarly.

According to the dynamic RAM as one preferred embodiment of the present invention thus constructed, the memory cells $M_{ijk}$ are arranged three dimensionally or stereoscopically, and one planar cell array formed on the same semiconductor layer is connted commonly to the same word line Wk. The bit lines $B_{ij}$ extend substantially perpendicularly to the word line pattern and connect commonly the memory cells $M_{ij1}$, $M_{ij2}$, ..., $M_{ijk}$, ... having the same row number and column number and formed on the different layers. Accordingly, the memory capacity can be increased as compared with the conventional memory element formed of the memory cells formed in two-dimensional manner on one semiconductive layer. Further, since the region cabable of connecting the bit line for the stacked cell structure extends planarly, a number of bit lines may be readily connected to the stacked cell structure. This is convenient for the data sorting or image information processing.

In other words, in the stacked memory cell structure shown in Figs. 1 and 2 and described in detail above, the word lines branched from one parent word line determines one virtual plane, to be named word-line routing plane, in which all the word lines branched from one parent word line are involved. The word lines $w_{11}$, $w_{21}$, $w_{31}$, ... which are branched from the parent word line W1 determines one word-line routing plane, say $P_1$, in which the word lines $w_{11}$, $w_{21}$, $w_{31}$, ... are involved. The word lines $w_{12}$, $w_{22}$, $w_{32}$, ... which are branched from the parent word line W2 determined one word-line routing plane, say $P_2$, in which the word lines $w_{12}$, $w_{22}$, $w_{32}$, ... are involved. More generally, the word lines $w_{1k}$, $w_{2k}$, $w_{3k}$, ... which are branched from the parent word line Wk determines one word-line routing plane $P_k$ in which the word lines $w_{1k}$, $w_{2k}$, $w_{3k}$, ... are involved. All these word-line routing planes $P_1$, $P_2$, ... which are assigned to parent word lines W1, W2, ..., respectively, are stacked and superposed substantially parallel to one another so that the word lines $w_{i1}$, $w_{i2}$, $w_{i3}$, ... which belong to the same row number "i" but to different word-line routing planes $P_1$, $P_2$, $P_3$, ..., respectively, are superposed to one after another. In other words, the word lines $w_{i1}$, $w_{i2}$, $w_{i3}$, ... determine one second word-line routing plane $Q_i$ in which all the word lines belonging to the same row number "i" are involved, and all the second word-line routing planes $Q_i$'s are substantially orthogonal to the first word-line routing planes $P_k$'s. Bit lines $B_{ij}$ are situated substantially perpendicularly to all the first word-line routing planes $P_k$'s. In the conventional memory cell array structure formed in two-dimensional manner on one semiconductor layer, both word lines and bit lines are arranged in two-dimensional manner, that is to say, word lines are substantially arranged in one plane while bit lines are substantially arranged in another plane, and both planes are superposed parallel to each other or substantially form one common plane. In the stacked memory cell structure shown in Figs. 1 and 2, word lines and bit lines are arranged mutually in three-dimensional manner as described above in detail, and this three-dimensional routing scheme makes it possible to connect a much larger number of bit lines for an ensemble of memory cells than the conventional two-dimensional routing scheme does.

Further, a plurality of word lines $w_{ik}$ drawn from each of the planar cell arrays are combined respectively with the parent word lines Wk corresponding to the number of the planar cell arrays. In other words, the memory cells included in the each planar cell array are respectively branched and connected commonly to one of the parent word lines Wk. In this manner, total word line length can be shortened, and hence the delay of the signal propagation speed can be reduced even at the terminal. Further, since the bit lines $B_{ij}$ are not necessarily laid complicatedly among the cells, the line length can be shortened. Therefore, the operating speed of the memory element can be improved.

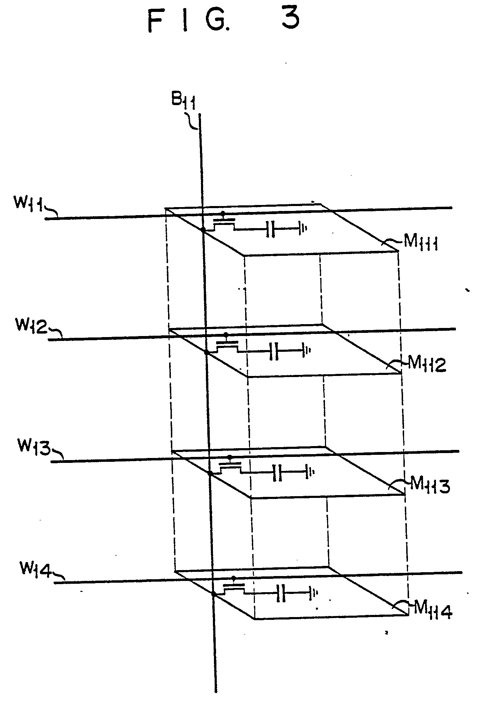

Fig. 3 illustrates one of the cell groups of a series of memory cells having the same row number and column number and formed in different planar cell array 12 in the memory cell structure of Fig. 2 particularly extracted. For the purpose of illustration only, memory cells $M_{111}$, $M_{112}$, $M_{113}$, $M_{114}$ are selected, and word lines $w_{11}$, $w_{12}$, $w_{13}$, $w_{14}$ are respectively connected to these memory cells. In Fig. 3, each of the memory cells $M_{111}$, $M_{112}$, $M_{113}$, $M_{114}$ includes one MOSFET and one capacitor.

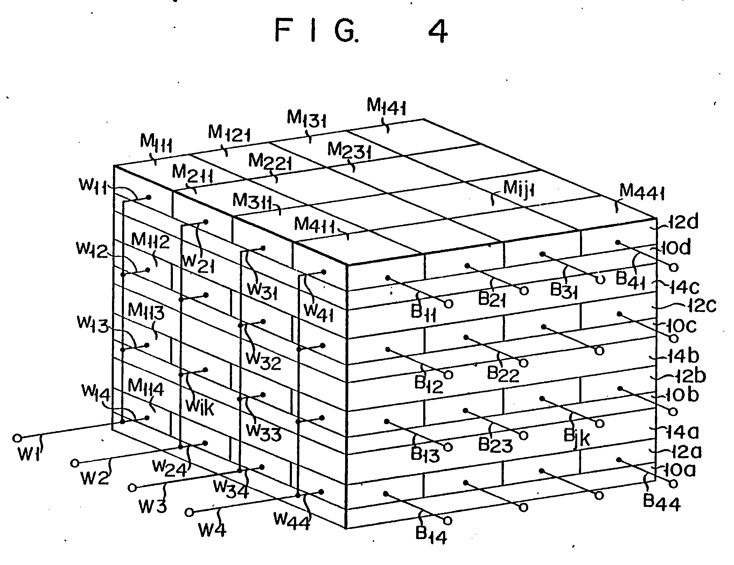

Fig. 4 illustrates a dynamic RAM similar to that of prior art (GB—A—1 300 881) wherein the like reference numerals designate the same or equivalent parts and components in Figs. 1 and 2, and will be omitted in description.

The same bit line $B_{ij}$ (e.g., bit line $B_{11}$) is connected commonly to a series of memory cells (e.g., memory cells $M_{111}$, $M_{211}$, $M_{311}$, $M_{411}$) having the same column number formed on the same semiconductor layer (e.g., layer 10d) in a plurality of memory cells $M_{ijk}$ included in the RAM in Fig. 4. Accordingly, a series of cells $M_{111}$, $M_{211}$, $M_{311}$, $M_{411}$, for example, are connected commonly to one bit line $B_{11}$, a series of memory cells $M_{121}$, $M_{221}$, ... are connected to one bit line $B_{21}$, a series of memory cells $M_{131}$, $M_{231}$, ... are connected to a bit line $B_{31}$, and a series of memory cells $M_{141}$, ..., $M_{441}$ are connected commonly to the bit line $B_{41}$ in the planar cell array 12d formed on the semiconductor layer 10d. These series of bit lines $B_{11}$, $B_{21}$, $B_{31}$, $B_{41}$ extend substantially parallel to each other, and are formed substantially parallel to the planar cell array 12d formed on the semiconductor layer 10d. In other words, the memory cell $M_{ij1}$ included in the planar cell array 12d is divided into a plurality of linear column cell arrays having the same column number and respectively connected commonly to the bit lines $B_{j1}$.

The bit lines $B_{12}$, $B_{22}$, ..., bit lines $B_{13}$, $B_{23}$, ... and bit lines $B_{14}$, ..., $B_{44}$ are connected commonly to a plurality of linear column cell arrays having the same column number in the same manner as above in the planar cell arrays 12c, 12b, 12a, respectively.

On the other hand, a series of memory cells having the same row number of the memory cells included in each of planar cell arrays 12 are connected commonly to the same word lines $w_{ik}$. Further, a plurality of word lines $w_{i1}$, $w_{i2}$, $w_{i3}$, $w_{i4}$ for respectively connecting a series of memory cell groups, each of which consists of linear cell arrays superposed to be elevationally aligned through the semiconductor layers 10, and insulating layers 14 are combined with one parent word line W1, W2, W3, W4. For example, in Fig. 4, a word line $w_{11}$ for commonly connecting the linear row cell array of a series of memory cells $M_{111}$, $M_{121}$, $M_{131}$, $M_{141}$ having the same row number of the planar cell array 12d on the semiconductor layer 10d, a word line $w_{12}$ for commonly connecting the memory cells $M_{112}$, $M_{122}$, $M_{132}$, $M_{142}$ linearly extending in parallel with the linear row cell array under the memory cells $M_{111}$, $M_{121}$, $M_{131}$, $M_{141}$ arranged linearly in series included in the planar cell array 12c, and word lines $w_{13}$ and

$w_{14}$ for commonly connecting the memory cells $M_{113}$, $M_{123}$, ... and $M_{114}$, $M_{124}$, ... superposed with the memory cells $M_{111}$, $M_{121}$, $M_{131}$, $M_{141}$ forming the linear cell arrays included in the planar cell arrays 12b, 12a are combined with one parent word line W1. In other words, the line pattern formed of the word lines $w_{11}$, $w_{12}$, $w_{13}$, $w_{14}$ branched from the parent word line W1 substantially intersect the planar cell arrays 12 or the above bit lines B formed respectively on the semiconductor layers 10.

Other series of word lines $w_{21}$, ..., $w_{24}$ are similarly combined with one parent word line W2. Further, other series of word lines $w_{31}$, ..., $w_{34}$ and the other series of word lines $w_{41}$, ..., $w_{44}$ are respectively combined with the parent word lines W3 and W4.

In this manner, even in the stereoscopic memory cell structure connected to the bit lines $B_{jk}$ and word lines Wi, the writing/reading of the digital data can be carried out similarly to the above-described embodiments.

According to the dynamic RAM in Fig. 4, the word line patterns branched from each of parent word lines Wi substantially intersect the planar cell array or bit lines B formed respectively on the semiconductor layers 10. Therefore, to drive the RAM thus constructed, an address decoder 20 designated, for example, in Fig. 5 is employed.

According to the address decoder in Fig. 5, decoder elements 22 are provided correspondingly to the planar cell arrays 12a, 12b, 12c, 12d superposed in laminar or stacked state with each other as described above. Reference numerals A1, A2 denote address input lines, and reference numerals $\overline{A1}$, $\overline{A2}$ designate inverting signal lines. The line pattern formed of these lines A1, $\overline{A1}$, A2, $\overline{A2}$ extend in parallel with each other and are included in a plane substantially perpendicular to the planar cell arrays 12 formed respectively on the semiconductor layers 10.

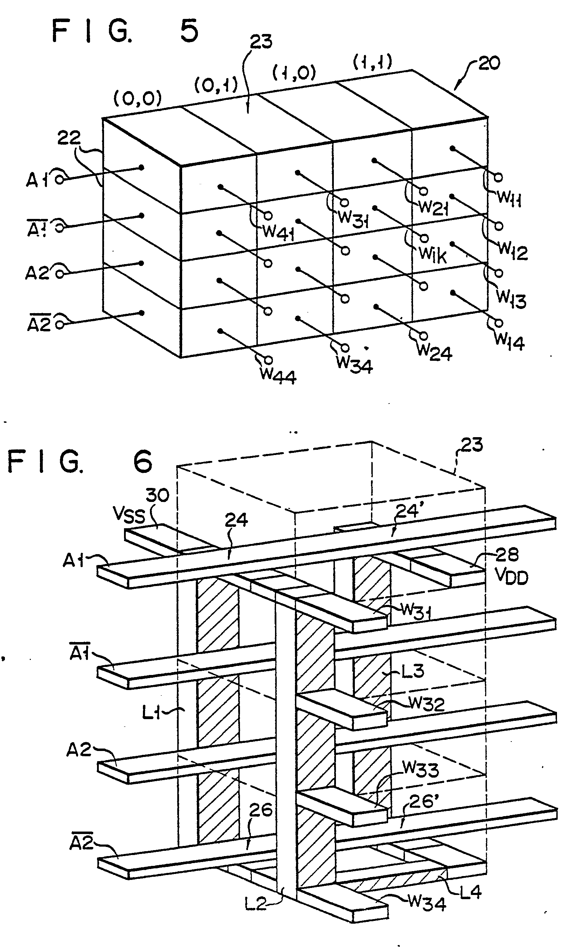

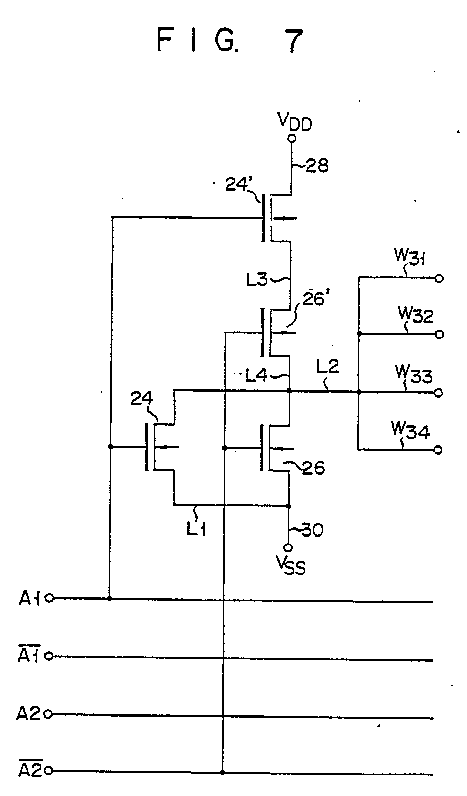

Fig. 6 illustrates a circuit block section 23 particularly extracted correspondingly to the word lines $w_{31}$, $w_{32}$, $w_{33}$, $w_{34}$ in the above RAM (Fig. 4) of the address decoder 20 in Fig. 5. The parent wordline W3 combined with the word lines $w_{31}$, ..., $w_{34}$ is activated when the digital levels of the address lines A1, A2 respectively become "0" and "1". The stereoscopic circuit in Fig. 6 includes n-channel type FETs 24, 26 and p-channel type FETs 24', 26' to form 2-input C-MOS NOR circuit. "High" power voltage $V_{DD}$ is supplied to the first power line 28 connected to the p-channel type FET 24'. "Low" power voltage $V_{SS}$ is applied to the second power line 30 connected to the n-channel type FETs 24, 26. In Fig. 6, electrically conductive connect lines L for electrically connecting between the FETs are shaded only for the purpose of readily distinguishing visually from the other section. In other words, n-channel type FETs 24 and 26 are connected in parallel with each other via the connect lines L1 and L2. The p-channel type FETs 24' and 26' are connected in series with each other via connect line L3. The connect line L4 connects between the n-channel type FET 26 and the p-channel type FET 26'. Accordingly, the FETs 24 and 24' are driven by the signal supplied from the input line A1, and the other FETs 26 and 26' are driven by the signal supplied from the inverting signal line $\overline{A2}$. No FET is provided in the circuit structure 23 in Fig. 6 corresponding to the remaining inverting signal line $\overline{A1}$ and input line A2. An equivalent circuit of the section of the address decoder in Fig. 6 thus constructed is shown in Fig. 7.

According to the circuit structure 23 of a part of the address decoder thus constructed, the word lines $w_{31}$, ..., $w_{34}$ are activated when the address input (A1, A2) becomes (0, 1). In this state, the word lines $w_{31}$, ..., $w_{34}$ are connected directly to one connect line L2 for connecting between the FETs 24 and 26 included in the decoder of Fig. 6 in their drain regions. In other words, the connect line L2 included in the address decoder substantially serves as the above-described parent word line W3. Accordingly, it is not necessary to newly provide a parent word line W3. It is not necessary by the same reason to newly provide other parent word lines W1, W2, W4. Therefore, the connection between the RAM in Fig. 4 and the address decoder in Fig. 5 can be efficiently performed, and the total line length can be shortened, thereby improving the signal propagation speed.

Although the parent invention has been shown and described with respect to particular embodiments, nevertheless, various changes and modifications which are obvious to a person skilled in the art to which the invention pertains are deemed to lie within the spirit, scope, and contemplation of the invention. In the embodiments described above, the dynamic RAM is shown and described. However, the present invention is not limited to the particular RAM, but may also be applied for other memory elements such as, for example, a static memory, a read-only memory, etc.

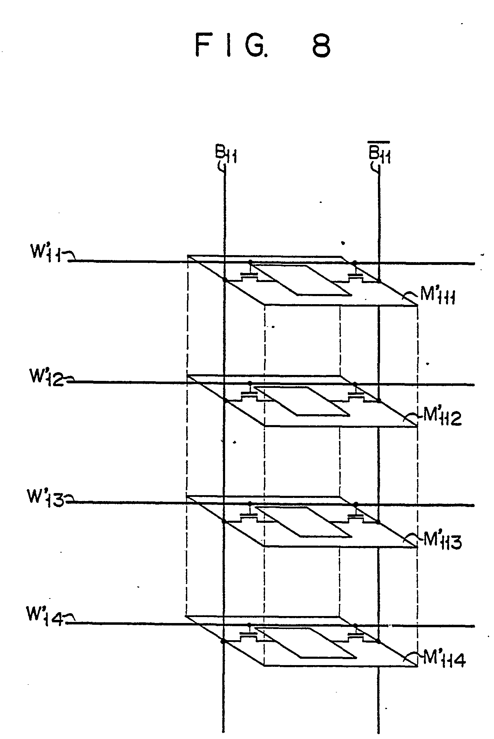

Fig. 8 illustrates one of the cell groups of a series of memory cells having the same row number and column number and formed in different planar cell array in the static type memory cell structure according to a modification of the preferred embodiment of the invention of Fig. 1 particularly extracted. For the purpose of illustration only, memory cells $M'_{111}$, $M'_{112}$, $M'_{113}$, $M'_{114}$ are selected, and word lines $w'_{11}$, $w'_{12}$, $w'_{13}$, $w'_{14}$ are respectively connected to these memory cells. In Fig. 8, each of the memory cells $M'_{111}$, $M'_{112}$, $M'_{113}$, $M'_{114}$ is applied with a flip-flop formed of MOSFETs, and a pair of bit lines $B_{11}$ and $\overline{B_{11}}$ are used as these memory cells. Voltage signals different from each other are supplied to these bit lines $B_{11}$ and $\overline{B_{11}}$.

**Claims**

1. A semiconductor memory having a plurality of semiconductor layers (10) sequentially stacked with each other to form a laminar structure, a plurality of memory cells (M) formed on each of said semiconductor layers (10) in a matrix form, and a plurality of insulative layers (14) each sandwiched between the respective semiconductor layers (10) for electrical insulation therebetween, characterized in that said memory device comprises:

a plurality of word lines (w) each assigned to a corresponding semiconductor layer (10) to commonly couple the memory cells (M) on that semiconductor layer; and

a number of bit lins (B) each of which electrically connects a set of memory cells which are formed on said semiconductor layers (10) respectively and are stacked one above another in a direction substantially perpendicular to surfaces of said semiconductor layers (10) and said insulative layers (14), which are alternatingly stacked on one another, said bit lines running through said semiconductor layers (10) and said insulative layers (14) to allow electrical signals to be transferred through said semiconductor and insulative layers (10, 14).

2. A semiconductor memory according to claim 1, characterized in that said number of said bit lines correspond to the number of memory cells (M) formed on each semiconductor layer (10).

3. A semiconductor memory according to claim 2, characterized in that said word lines, associated with said corresponding semiconductor layers (10), comprise:

branched word lines ($w_{11}$, $w_{21}$, ..., $w_{lk}$) each for commonly coupling a corresponding row of memory cells on said corresponding semiconductor layer (10); and

parent lines (W1, W2, W3, W4) for electrically connecting said branched word lines.

4. A semiconductor memory according to claim 3, characterized in that said laminar structure comprises four semiconductor layers (10a, 10b, 10c, 10d) and three insulative layers (14a, 14b, 14c) and that said bit lines (B) perpendicularly penetrate said three insulative layers (14a, 14b, 14c).

5. A semiconductor memory system comprising a semiconductor memory and decoder means (20) for receiving an address input signal and for activating desired memory cells of said semiconductor memory, wherein said semiconductor memory comprises a plurality of layers (10) electrically isolated from each other and sequentially stacked to form a laminar structure, a plurality of cell matrix structures (12) having a plurality of memory cells aligned in row and column directions on the surface of said layers, a plurality of bit lines (B) for commonly connecting a plurality of first linear memory cell arrays respectively formed of memory cells arranged in the same column direction of the memory cells included in the cell matrix structure on each of said layers, and a plurality of word lines for commonly connecting a plurality of second linear memory cell arrays formed of memory cells arranged in the same row direction of the memory cells included in the memory cell matrix structure on each of said layers and substantially orthogonally intersecting the first linear memory cell arrays, characterized in that said decoder means (20) is electrically connected through said word lines (w) to said semiconductor memory, stacked correspondingly to laminar units formed respectively of said plurality of second linear memory cell arrays stacked via said layers and formed by arranging in parallel with each other a plurality of linear decoder element arrays (23) respectively formed of a plurality of stacked decoder elements (22) including active elements (24, 24', 26, 26'), each of said linear decoder element arrays (23) including wiring means (L2) for commonly connecting said plurality of word lines ($w_{31}$, $w_{32}$, $w_{33}$, $w_{34}$) which respectively connect a plurality of second linear memory cell arrays stacked with each other and included in each of said laminar units corresponding to the linear decoder element array (23) and for connecting between predetermined said active elements (24, 26) provided therein, said wiring means (L2) extending to substantially orthogonally intersect said layers (12).

**Patentansprüche**

1. Halbleiterspeicher mit mehreren Halbleiterschichten (10), die zur Bildung einer laminaren Struktur übereinandergestapelt sind, mit mehreren Speicherzellen (M), die auf den jeweiligen Halbleiterschichten in Matrixform ausgebildet sind, und mit mehreren isolierenden Schichten (14), die jeweils zwischen den entsprechenden Halbleiterschichten (10) zur elektrischen Isolierung voneinander angeordnet sind, dadurch gekennzeichnet, daß die Speichereinrichtung umfaßt:

mehrere Wortleitungen (w), die jeweils einer entsprechenden Halbleiterschicht (10) zugeordnet sind, um die Speicherzellen (M) auf dieser Halbleiterschicht zusammen zu verbinden, und

eine Anzahl von Bitleitungen (B), die jeweils einen Satz von Speicherzellen verbindet, welche auf den entsprechenden Halbleiterschichten (10) ausgebildet und eine über die andere gestapelt sind in einer Richtung im wesentlichen senkrecht zu den Oberflächen der Halbleiterschichten (10) und der isolierenden Schichten (14), welche wechselweise übereinandergestapelt sind, wobei die Bitleitungen durch die Halbleiterschichten (10) und isolierenden Schichten (14) hindurchlaufen, um die Übermittlung elektrischer Signale durch die Halbleiter- und isolierenden Schichten (10, 14) zu ermöglichen.

2. Halbleiterspeicher nach Anspruch 1, dadurch gekennzeichnet, daß die Anzahl der Bitleitungen der Anzahl der auf jeder Halbleiterschicht (10) ausgebildeten Speicherzellen (M) entspricht.

3. Halbleiterspeicher nach Anspruch 2, dadurch gekennzeichnet, daß die den entsprechenden Halbleiterschichten (10) zugeordneten Wortleitungen umfassen:

verzweigte Wortleitungen ($w_{11}$, $w_{21}$, ..., $w_{lk}$) jeweils zum Anschluß einer entsprechenden Zeile von Speicherzellen auf der entsprechenden Halbleiterschicht (10) und

Hauptleitungen (W1, W2, W3, W4) zur elektrischen Verbindung der verzweigten Wortleitungen.

4. Halbleiterspeicher nach Anspruch 3, dadurch gekennzeichnet, daß die laminare Struktur vier Halbleiterschichten (10a, 10b, 10c, 10d) und drei isolierenden Schichten (14a, 14b, 14c) umfaßt und daß die Bitleitungen (B) die drei isolierenden Schichten (14a, 14b, 14c) senkrecht durchdringen.

5. Halbleiterspeichersystem, umfassend einen Halbleiterspeicher und eine Dekodiereinrichtung (20) zum Empfangen eines Adresseneingangssignals und zum Aktivieren der gewünschten Speicherzellen des Halbleiterspeichers, wobei der Halbleiterspeicher mehrere Schichten (10) umfaßt, die voneinander isoliert und zur Bildung einer laminaren Struktur übereinandergestapelt sind, sowie mehrere Zellenmatrixstrukturen (12) mit mehreren Speicherzellen, die in Zeilen- und Spaltenrichtung auf den Oberflächen dieser Schichten ausgerichtet sind mehrere Bitleitungen (B) zur gemeinsamen Verbindung von mehreren ersten linearen Speicherzellenanordnungen, die jeweils aus Speicherzellen gebildet sind, welche in der gleichen Spaltenrichtung der in der Zellenmatrixstruktur auf jeder dieser Schichten enthaltenen Speicherzellen angeordnet sind, und mehrere Wortleitungen (B) zum gemeinsamen Verbindung von mehreren zweiten linearen Speicherzellenanordnungen, die jeweils aus Speicherzellen gebildet sind, welche in der gleichen Zeilenrichtung der in der Zellenmatrixstruktur auf jeder dieser Schichten enthaltenen Speicherzellen angeordnet sind, und die ersten linearen Speicherzellenanordnungen im wesentlichen senkrecht schneiden, dadurch gekennzeichnet, daß die Dekodiereinrichtung (20) über die Wortleitungen (w) mit dem Halbleiterspeicher elektrisch verbunden und entsprechend laminaren Einheiten gestapelt ist, die jeweils aus den mehreren zweiten linearen Speicherzellenanordnungen gebildet sind, welche über diese Schichten gestapelt sind, sowie durch zueinander parallele Anordnung von mehreren linearen Dekodierelementenanordnungen (23) gebildet ist, die jeweils aus mehreren gestapelten Dekodierelementen (22) mit aktiven Elementen (24, 24', 26, 26') gebildet sind, wobei jede der linearen Dekodierelementenanordnungen (23) Verbindungsmittel (L2) enthält zur gemeinsamen Verbindung der mehreren Wortleitungen ($w_{31}$, $w_{32}$, $w_{33}$, $w_{34}$), welche jeweils mehrere zweite lineare Speicherzellenanordnungen verbinden, die übereinandergestapelt und in jeder der laminaren Einheiten enthalten sind, die der linearen Dekodierelementenanordnung entsprechen, und zur Verbindung zwischen vorbestimmten, darin vorgesehenen aktiven Elementen (24, 26), und wobei die Verbindungsmittel (L2) sich derart erstrecken, daß sie die Schichten (10) im wesentlichen senkrecht schneiden.

**Revendications**

1. Mémoire à semi-conducteur comportant plusieurs couches semi-conductrices (10) empilées séquentiellement les unes sur les autres pour former une structure laminaire, plusieurs cellues de mémoire (M) formées sur chacune desdites couches semi-conductrices (10) sous la forme d'une matrice et plusieurs couches isolantes (14) intercalées chacune entre les couches semi-conductrices (10) respectives pour les isoler électriquement entre elles, caractérisée en ce que ladite mémoire comporte:

plusieurs lignes de mots (w) affectées chacune à une couche semi-conductrice (10) correspondante pour coupler en commun les cellules de mémoire (M) sur cette couche semi-conductrice; et

un certain nombre de lignes de bits (B) dont chacune connecte électriquement un ensemble de cellules de mémoire que sont formées sur lesdites couches semi-conductrices (10) respectivement et qui sont empilées les unes au-dessus des autres dans une direction pratiquement perpendiculaire aux surfaces desdites couches semi-conductrices (10) et desdites couches isolantes (14) qui sont alternativement empilées les unes sur les autres, lesdites lignes de bits s'étendant à travers lesdites couches semi-conductrices (10) et lesdites couches isolantes (14) pour premettre que des signaux électriques soient transférés par lesdites couches semi-conductrices et isolantes (10, 14).

2. Mémoire à semi-conducteur selon la revendication 1, caractérisée en ce que ledit nombre desdites lignes de bits correspond au nombre des cellules de mémoire (M) formées sur chaque couche semi-conductrice (10).

3. Mémoire à semiconducteur selon la revendication 2, caractérisée en ce que lesdites lignes de mots associées avec lesdites couches semi-conductrices (10) correspondantes comportent:

des lignes de mots branchées ($W_{11}$, $W_{22}$, ... $w_{lk}$) destinées chacune à coupler en commun une rangée correspondante de cellules de mémoire sur ladite couche semi-conductrice (10) correspondante; et

des lignes mères (W1, W2, W3, W4) destinées à connecter électriquement lesdites lignes de mots branchées.

4. Mémoire à semi-conducteur selon la revendication 3, caractérisée en ce que ladite structure laminaire comporte quatre couches semi-conductrices (10a, 10b, 10c, 10d) et trois couches isolantes (14a, 14b, 14c) et en ce que lesdites lignes de bits (B) pénètrent perpendiculairement les trois couches isolantes (14a, 14b, 14c).

5. Système de mémoire à semi-conducteur comportant une mémoire à semi-conducteur et un dispositif décodeur (20) pour recevoir un signal d'entrée d'adresse et pour activer des cellules de mémoire voulues de ladite mémoire semi-conductrice, dans lequel ladite mémoire semi-conductrice comporte plusieurs couches (10) isolées électriquement les unes des autres et empilées séquentiellement pour former une structure laminaire, plusieurs structures de matrices de cellules (12) comprenant plusieurs cellules de mémoire alignées dans les directions des rangées et des colonnes sur la surface desdites couches, plusieurs lignes de bits (B) pour connecter en commun plusieurs de premiers réseaux linéaires de cellules de mémoire formés respectivement de cellules de mémoire disposées dans la même direction de colonnes de cellules de mémoire incluses dans la structure de matrices de cellules sur chacune desdites couches et plusieurs lignes de mots pour connecter en commun plusieurs seconds réseaux linéaires de cellules de mémoire formés de cellules de mémoire disposés dans la même direction de rangées des cellules de mémoire incluses dans la structure de matrices de cellules de mémoire sur chacune desdites couches et coupant pratiquement perpendiculairement les premiers réseaux linéaires de cellules de mémoire, caractérisé en ce que ledite dispositif décodeur de mémoire (20) est connecté électriquement, par lesdites lignes de mots (w) à ladite mémoire semiconductrice, empilé de façon correspondante à des unités laminaires formées respectivement desdits plusieurs seconds réseaux linéaires de cellules de mémoire empliées par lesdites couches et formés en disposant en parallèle entre eux plusieurs réseaux (23) linéaires d'éléments décodeurs formés respectivement de plusieurs éléments décodeurs empilés (22), comprenant des éléments actifs (24, 24', 26, 26'), chacune desdites réseaux linéaires d'éléments décodeurs (23) comprenant un dispositif de connexion (L2) pour connecter en commun lesdites plusieurs lignes de mots ($w_{31}$, $w_{32}$, $w_{33}$, $w_{34}$) qui connectent respectivement plusieurs des seconds réseaux linéaires de cellules de mémoire empilés les uns sur les autres et inclus dans chacune desdites unités laminaires correspondant au réseau linéaire d'éléments décodeurs (23) et pour établir une connexion entre lesdits éléments actifs prédéterminés (24, 26) qui y sont produits, ledit dispositif de connexion (L2) s'étendant de manière à couper pratiquement perpendiculairement lesdites couches (12).

F I G. 1

FIG. 2

# F I G. 3

F I G. 4

EP 0 073 486 B1

F I G. 5

F I G. 6

# F I G. 7

# F I G. 8